# EUROPEAN PATENT APPLICATION

(11) **EP 1 906 157 A2**
(43) Date of publication of application: **02.04.2008**
(21) Application number: 07017885.0
(22) Date of filing: 12.09.2007
(51) Int. Cl.: G01F 3/08, G01F 15/02, G01F 15/06

(54) **Power system architecture for fluid flow measurement systems**

(30) Priority: 29.09.2006 US 537188
(71) Applicant: DRESSER, INC., Addison, TX 75001 (US)
(72) Inventor: Gutierrez, Francisco M., League City Texas 77573-0898 (US)
(74) Representative: UEXKÜLL & STOLBERG

(57) **Abstract**

An architecture to supply electrical operating power in fluid flow measurement applications, apparatus and associated systems, computer program products, and methods include a receiver tunable to various radio frequencies to capture radio frequency (RF) energy that may be used to supply regulated voltage to electronic fluid flow measurement data processing circuitry. In an example implementation, the power module searches for at least one RF signal that contains substantial energy. The received energy may be converted to a rectified waveform. The converted energy may be, for example, used to supply operating power to circuits in the fluid flow measurement circuitry, and/or it may be stored, such as in a capacitor or in a battery. Preferred embodiments may store signal strength information for one or more frequencies in at least one range of frequencies, and may tune the receiver to a frequency selected from the stored frequency information.

## Description

### TECHNICAL FIELD

Various embodiments relate to fluid flow measurement systems, and particular embodiments relate to power systems for operating equipment in fluid flow measurement applications.

### BACKGROUND

Fluids, which may be in liquid or gas state, are often transported, distributed, and/or sold to customers through a system of transmission and distribution lines. For purposes such as billing and inventory control, for example, fluid flow measurement systems may be installed at various locations along these lines. Gas metering systems, for example, may measure the volume of gas that flows through a particular gas line. Fluid measurement systems typically include a fluid flow meter and an electronic or mechanical indicator or index.

As an illustrative example, one type of fluid flow meter is a rotary meter for measuring a volume of gas through a gas line. In some rotary meters, gas flowing through the meter causes a set of impellers to rotate within a cylinder. This type of meter is normally referred to as a rotary positive displacement meter. As the impellers turn, they measure a displaced volume of gas that is fixed and determined by the area between the impeller and cylinder. Each impeller rotation indicates that a certain volume of gas has flowed through the meter. This is normally referred to as "actual" volume as measured by the primary flow element that is in this case a rotary positive displacement meter. Buying and selling of natural gas typically requires that the actual volume be converted to "standard" volume to account for the contraction or expansion of gas due to varying gas pressure and gas temperature. In general, these effects may be described by Boyle's and Charles' Law. To convert actual volume to standard volume, some gas metering systems use an electronic volume corrector to correct actual volume measurement originating from the rotating impellers to account for temperature or pressure of the gas in the meter.

In general, fluid flow measurement systems often can be applied in harsh conditions, subject to extremes in temperatures, weather, contaminants, and/or mechanical vibration. Furthermore, some fluid flow measurement systems may be installed in locations that are remote or otherwise difficult to access for maintenance purposes. Moreover, electronics to provide volume correction functions consume electrical power for which batteries may be the only readily available source.

Accordingly, maintaining fluid flow measurement systems that operate from battery power typically involves battery related maintenance. Batteries can have various electrical and/or mechanical failure mechanisms. For example, batteries can develop leaks, depleted charge, short circuits, overheating, high internal resistance, or open circuits. Moreover, contacts may fail to provide sufficient continuity to the battery terminals due to contamination or vibration. A significant portion of the lifetime cost of maintaining some liquid and gas fluid flow measurement systems may be attributable to battery-related faults.

### SUMMARY

An architecture to supply electrical operating power in fluid flow measurement applications, apparatus and associated systems, computer program products, and methods include a receiver tunable to various radio frequencies to capture electromagnetic energy that may be used to supply regulated voltage to electronic fluid flow measurement data processing circuitry. In an example implementation, the power module searches for at least one RF (radio frequency) signal that contains substantial energy. The received energy may be converted to a rectified waveform. The converted energy may be, for example, used to supply operating power to circuits in the fluid flow measurement circuitry, and/or it may be stored, such as in a capacitor or in a battery. Preferred embodiments may store signal strength information for one or more frequencies in at least one range of frequencies, and may tune the receiver to a frequency selected from the stored frequency information.

Some embodiments may have one or more advantages. For example, sensitivity to single point faults in the power supply systems, such as batteries or their connections, for instance, may be reduced. As such, fault tolerance of electrical measurement devices exposed to rugged field installation conditions, such as vibration and corrosion, may be improved. In various fluid flow meter installations, electronics may be powered partially or exclusively by captured electromagnetic energy, which may, in some installations, substantially reduce or eliminate the need for other energy sources, such as batteries, solar panels, or external energy sources (e.g., electric utility grid power). Some embodiments may provide battery charging, which may improve utilization of a stored energy source, and thereby extend time between maintenance operations for a fluid flow measurement system. Furthermore, some embodiments may provide monitoring and reporting capabilities that may reduce unnecessary maintenance-related labor and materials expenses, help to identify points of failure, and/or promote increased system availability.

The details of one or more embodiments of the invention are set forth in the accompanying drawings and the description below. Other features, objects, and advantages of the invention will be apparent from the description and drawings, and from the claims.

### DESCRIPTION OF DRAWINGS

FIGS. 1-2 show exemplary fluid flow measurement systems that include a radio frequency (RF) energy capture module.

FIG. 3 shows an exemplary energy capture module that transmits and receives RF signals.

FIG 4 shows an exemplary energy capture module with multiple antennas.

FIG. 5 is a flow chart showing exemplary method to search for RF sources from which energy may be captured.

FIG. 6 is a flow chart showing exemplary operations to capture RF energy.

### DETAILED DESCRIPTION OF ILLUSTRATIVE EXAMPLES

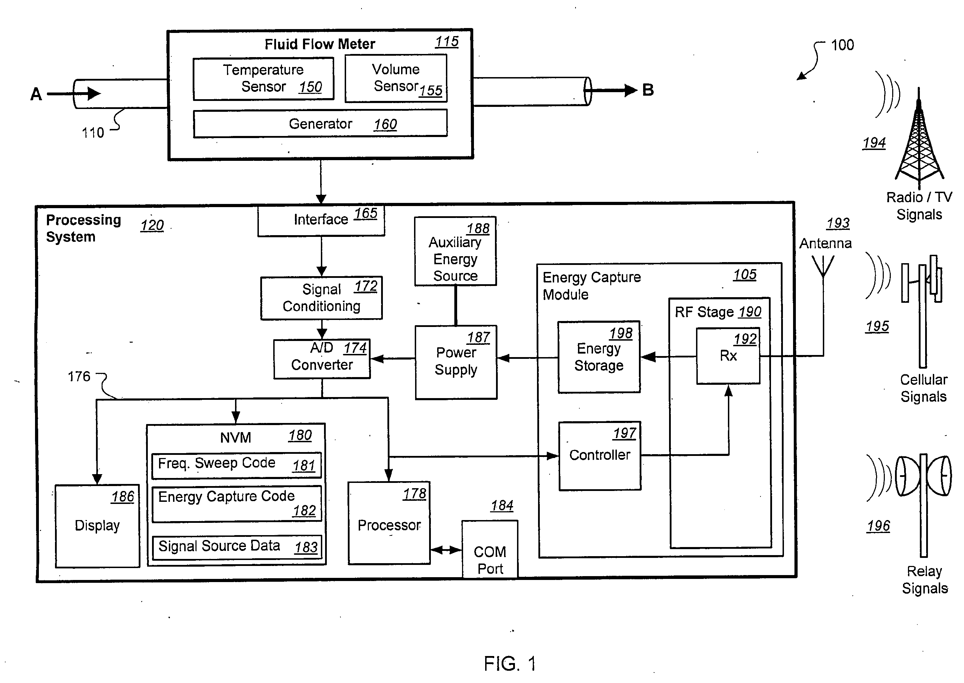

FIG. 1 shows an exemplary fluid flow measurement system 100 that includes an energy capture module 105, a fluid line 110, a fluid flow meter 115, and a processing system 120. In this example, fluid, which may be in gas or liquid form, flows in the fluid line 110 in the direction indicated by arrows A and B. The volume of fluid that flows through the fluid line 110 is measured by the fluid flow meter 115, which may be a gas flow meter or a liquid flow meter, for example. The measured data is processed by the processing system 120 that may operate using electrical power supplied from the energy capture module 105. Examples of the processing system 120 may be a fluid flow accumulator, totalizer, corrector, or similar fluid flow measurement processing device.

In some implementations, the fluid line 110 can be a gas line that transports gasses, such as natural gas, argon, butane, carbon monoxide, carbon dioxide, ethane, nitrogen, oxygen, propane, or air. In other implementations, the fluid line 110 can be a liquid line that transports water, crude oil, petroleum, gasoline, chemical solutions, or waste water. The fluid flow meter 115 includes a temperature sensor 150, a volume sensor 155 and, optionally, a generator 160. When fluid flows through the fluid flow meter 115, the fluid flow meter 115 measures fluid flow information, such as pressure and temperature in the fluid line 110. The fluid flow meter 115 communicates the measured information to the processing system 120. The processing system 120 receives the signals via an interface 165 (which may include electrical and/or mechanical inputs) to determine a quantity of fluid, such as a volume of gas, flowing through the fluid flow meter 115: For example, the processing system 120 may use the temperature information from the temperature sensor 150 to convert actual gas volume to standard gas volume based on Charles' Law.

In the depicted example, generator 160 converts mechanical energy from the fluid flow into electrical energy. For example, the fluid flow meter 115 may measure the pressure of the fluid flow using rotating impellers. The generator 160 may convert the kinetic energy of the rotating impellers to independently generate electricity to power the processing system 120, either alone or in combination with power supplied by other sources, such as a battery or the energy capture module 105. Some exemplary embodiments of the generator 160 are described in U.S. Patent 6,886,414 to Gutierrez et al., entitled "Power Generating Meter," which issued on May 3, 2005, the entire contents of which are incorporated herein by reference.

The received signals, such as the line pressure, the temperature, and the volume signals, are processed by a signal conditioning circuit 172 and an A/D (analog to digital) converter 174. The signal conditioning circuit 172 may include analog amplification and/or scaling to modify the input signal for interfacing to the A/D converter 174. As shown, the A/D converter 174 processes analog signals from the signal conditioning circuit 172 and the power supply 187. In some embodiments, the A/D 174 may receive signals from the fluid flow meter 115 or the energy capture module 105, including an input voltage to the power supply 187. For example, the A/D converter 174 may receive an encoded output signal from the energy capture module 105. The A/D converter 174 outputs a serial or parallel data signal representing samples of the input signal(s) onto a digital bus 176.

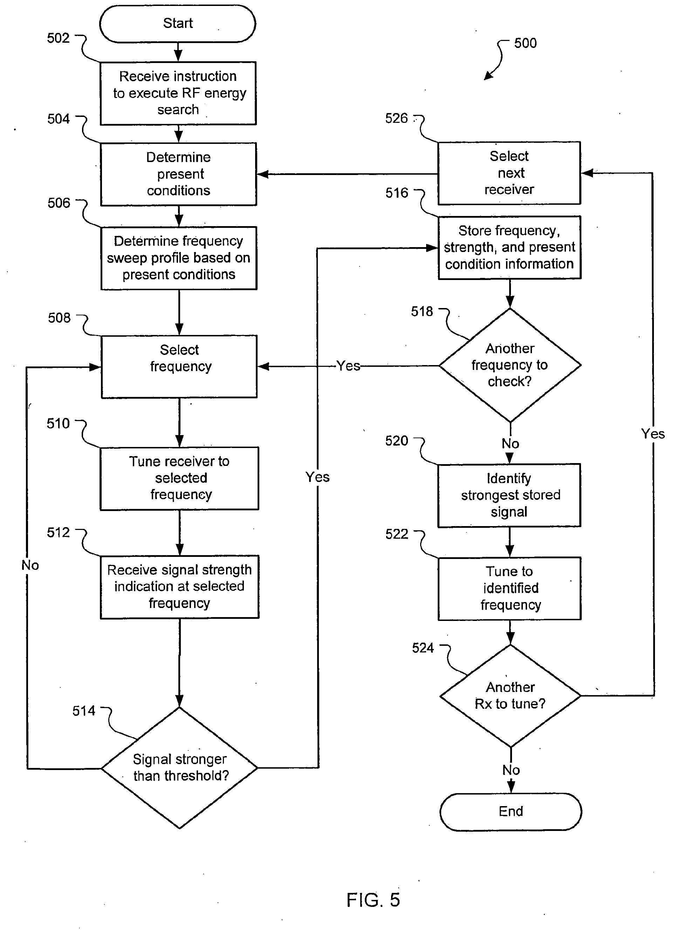

The bus 176 couples to a processor 178 and a non-volatile memory (NVM) 180. The processor 178 may include one or more processing devices that are operable to execute instructions (e.g., software, firmware) to perform operations. For example, the processor 178 may include a microcontroller, microprocessor, DSP, and/or math co-processor. The NVM 180 may store program, control, data, metadata, and/or other information for access by the processor 178. For example, the processor 178 may access information stored in the NVM 180 such as signal source data 183. In some embodiments, the processor 178 may look up RF (radio frequency) signal source data 183 to select RF frequencies that yield the highest energy output level from the energy capture module 105 for a given set of environmental conditions. The NVM 180 also stores a set of program instructions, including frequency sweep code 181 and energy capture code 182. The processor 178 may execute frequency sweep code 181 to select a frequency for energy capture operations. The processor 178 may execute energy capture code 182 to tune energy capture module 105 for energy capture operations. Examples of such signal source data and such code are described in further detail with reference to FIGS. 5-6.

The processing system 120 also includes a COM port 184. In some implementations, the COM port 184 may provide two-way communication with other devices. For example, the COM port 184 may be used to link to a download terminal of a laptop or a handheld computer to send collected measurement and/or maintenance request signals. In another example, an external device may send instructions, such as a check RF source status instruction, to the processing system 170 via the COM port 184. Upon receiving the check RF source status instruction, the processor 178 may perform the RF source status instruction to check the status of the signal source data 183. Then the processor 178 can send the result to the device using the COM port 184. In some embodiments, the COM port 184 may communicate with the external device using a wireless interface, such as a wireless network interface card (WIVIC), to connect to a radio based network or an Infrared (I/R) interface. In various embodiments, the COM port 184 may connect to the external device via a Universal Serial Bus (USB) interface, for example.

The processing system 120 also includes a display 186, such as a liquid crystal display (LCD) monitor, a thin-film transistor (TFT) monitor, or a Light-emitting diode (LED) screen. The processor 178 may transmit text messages and/or graphical messages to the display 186. For example, when a battery needs replacement, the processor 178 may display an alert message on the display 186 to indicate a rate of energy capture from an RF source.

The processing system 120 further includes a power supply 187 to supply, for example, regulated voltage for operation of the processor 178. The power supply 187 may include one or more voltage regulators, for example, to supply operating power to various circuits around one or more voltages that may include, but are not limited to, 1.5 V, 3.0 V, 3.3 V, +/- 5V, +/- 10V, and 20V. Examples of voltage regulators may include, for example, linear, low dropout, switched-mode (e.g., buck, boost, buck-boost, SEPIC, CUK, flyback, forward), switched-capacitor type supplies, or series or parallel combinations thereof.

The energy capture module 105 includes an RF stage 190 that has a receiver 192 coupled to an antenna 193 which may be configured to receive RF signals from any number of broadcast sources, such as a radio and/or television transmitter 194, cellular network transmitter 195, communications relay transmitter 196, or other RF transmission sources.

The receiver 192 may be tuned to various frequencies by a controller 197 that is responsive to the processor 178. The processor 178 may determine the present operational conditions (e.g., time of day, day of year, temperature, humidity, power state) to determine received energy or signal strength at various frequencies. Based on the present conditions, the processor 178 may retrieve frequency values from the signal source data 183 stored in the NVM 180. The processor 178 may convey a frequency to use to the controller 197. In this example, these commands are conveyed between the processor 178 and the controller 197 by a direct connection to a serial and/or parallel data bus 176, which may be a direct connection, RS-232, RS-422, I2C, USB, or the like. The controller 197 interprets these commands, and responds by generating control signals to tune the receiver 192 to the selected frequency.

When tuned to an active radio/TV signal 194, cellular network signal 195, relay signal 196, or other RF signal, the receiver 192 passes the received signal energy to an energy storage module 198. In some embodiments, the energy storage module 198 may rectify the received signal to form a DC or quasi-DC signal. The rectified signal may be stored and/or supplied directly to the power supply 187. In some embodiments, the energy storage module 198 may supply power directly to the power supply 187. In some embodiments, the energy storage module 198 may supply energy to charge a battery, capacitor, or other energy storage element. The stored energy may subsequently be used to provide operating power for the processing system 120.

In some embodiments, the receiver 192 may not include an energy storage module 198, and the receiver 192 may supply power directly to the power supply 187.

The receiver 192 may provide a passband with bandwidth response over which energy is preferentially selected. The passband selection may depend on, for example, a quality factor (Q) of the receiver at the selected frequency. As such, RF signal energy at the frequencies around the selected frequency may be captured in the energy capture module.

In some embodiments, the selectivity of the receiver 192 may be controllable. A wider passband (less selective) may enhance RF energy capture for some RF sources, while a narrower passband may enhance RF energy capture for other RF sources. In an exemplary implementation, while tuned to a particular frequency, the quality factor (Q) of the receiver may be varied in response to a control signal. In some implementations, two or more discrete Q factors may be achieved by circuit component value selection according to a digital command value. In some implementations, Q-factor may be substantially adjustable within a range of values, for example, using a linear op-amp circuit or a high resolution digital to analog converter.

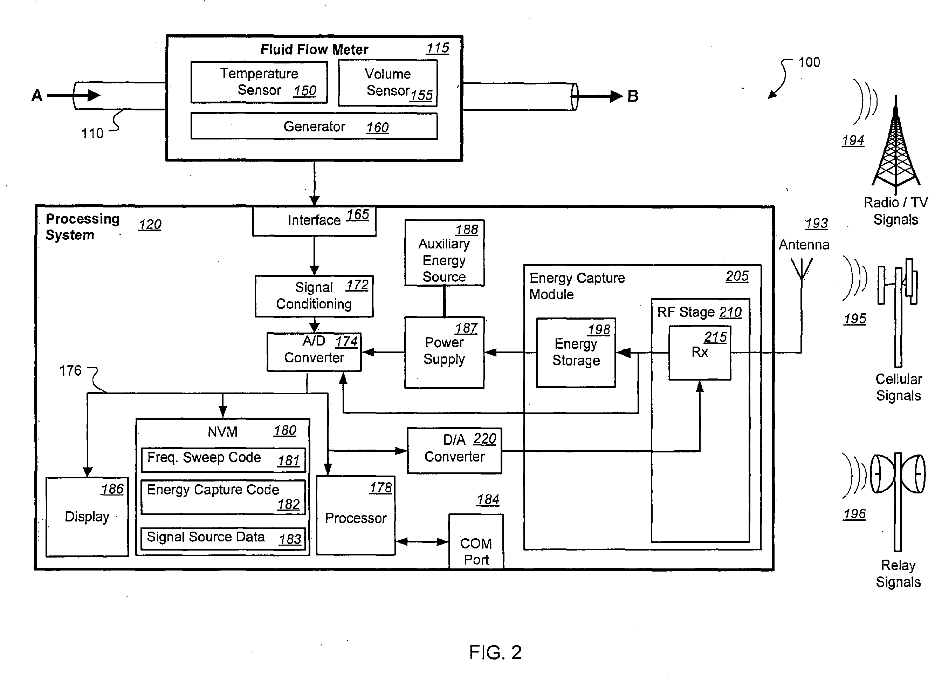

FIG. 2 represents another exemplary embodiment of the fluid flow measurement system 100. In this example, the system 100 includes a D/A (digital-to-analog) converter 220, an energy capture module 205, and an RF stage 210 with a receiver 215. The receiver 215 may be tuned, for example, by varying an analog voltage or current. In this example, the processor 178 may select a frequency and send a corresponding digital command to a D/A converter 220. The D/A converter 220, responsive to the command from the processor 178, produces an analog voltage that causes the receiver 215 to tune to the selected RF frequency. In some embodiments, the analog voltage may be used to bias a variable capacitor (e.g., varactor diode) in that tuning circuit.

In some embodiments, the D/A converter 220 and/or the A/D converter 174 of the processing system 120 may be integrated into a single unit. In some other embodiments, the D/A converter 220 and or A/D converter 174 may be integrated into the processor 178.

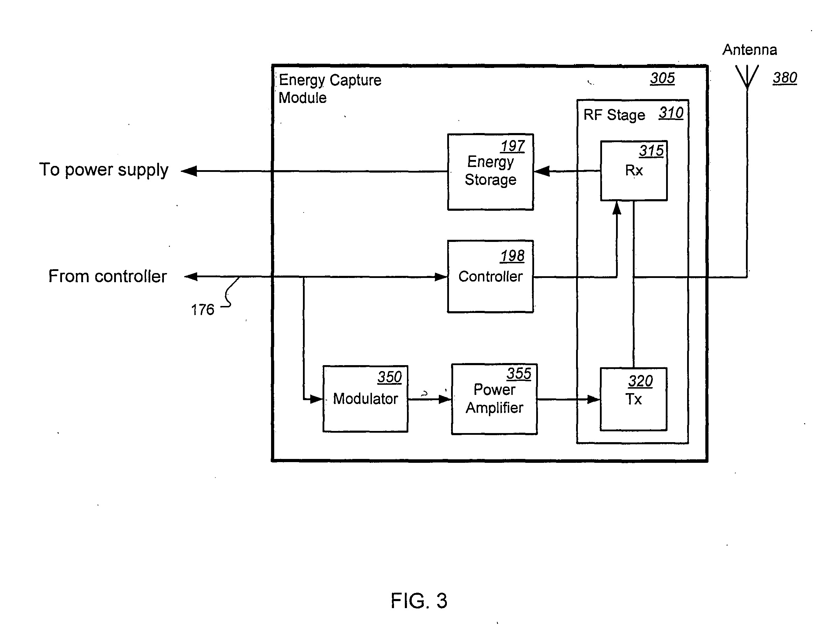

FIG. 3 shows an exemplary embodiment of an energy capture module 305 that is capable of receive and transmit operations. The energy capture module 305 may be implemented, for example, in embodiments of the fluid flow measurement system 100 of FIGS. 1-2.

The energy capture module 305 includes an RF stage 310 with a receiver 315 that is capable of capturing RF energy as well as receiving RF data signals. The RF stage 310 also includes a transmitter 320 to enable the processing system 120 to receive signals from, and transmit signals to, external devices (e.g., a meter reading device, cellular uplink, radio modem) as well as capture RF energy. The transmitter 320 and the receiver 315 are both coupled to an antenna 380. In some embodiments, the transmitter 320 may be coupled to an antenna that is used for transmission, and the receiver 315 may be coupled to a separate antenna that is used for reception. In the depicted embodiment, a modulator 350 receives commands from the processor 178 via a data bus 176 that is shared with the controller 198. In some embodiments, the modulator may have a dedicated data bus for receiving data from the processor 178. The modulator 350 creates a signal that is receivably connected to a power amplifier 355 for amplification, and this amplified output is receivably connected to the transmitter 320 for transmission to a remote receiver (not shown).

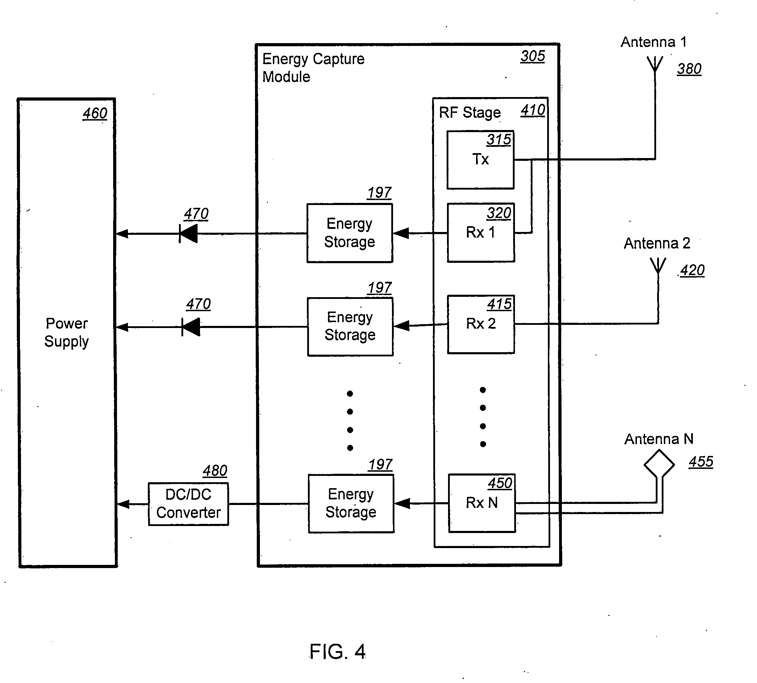

FIG. 4 illustrates another exemplary embodiment of the energy capture module 305 for the fluid flow measurement system 100. In this embodiment, the RF stage 410 includes a second receiver 415 coupled to a second antenna 420. The second receiver 415 and the second antenna 420 may be configured to capture energy at a second frequency.

In an illustrative example, the first receiver 320 and the antenna 380 may be tuned to capture energy at 101.5 MHz, while the second receiver 415 and the antenna 420 may be tuned to capture energy at 35 kHz. In another illustrative example, the first receiver 320 may be tuned to an AM broadcast, the second receiver 415 may be tuned to a television broadcast, and the transmitter 315 may be tuned to send signals (e.g., corrected fluid flow volume information, energy capture performance information) to a technician's tool for maintenance operations.

In some embodiments, the second antenna 420 may be positioned differently than the antenna 380 in order to capture a second signal. In some embodiments, the second receiver 415 and second antenna 420 may be designed and tuned differently in order to capture RF energy from a different frequency band than the receiver 320 and antenna 380.

The RF stage 410 may be made up of any number of additional receivers, such as a receiver 450, and corresponding antennas, such as an antenna 455, in order to capture RF energy across any number of additional frequency sources, bands, polarizations, and/or directions. For example, the receiver 320 may be tuned to an AM radio broadcast, the receiver 415 may be tuned to a television broadcast, and receiver 450 maybe tuned to a cellular signal. The overall collection of receivers in the RF stage 410 may increase the amount of total energy captured, or provide fault tolerance by capturing energy from redundant RF energy sources.

Diodes, such as a diode 470, DC/DC converters, such as a DC/DC converter 480, and/or other unidirectional circuitry may be used to combine power supplied to the power supply 460 from multiple sources. In the depicted example, the receivers 315, 415, and 450 connect to a power supply 460. The power supply 460 is configured to accept multiple power inputs for multiple receivers. In some embodiments, the DC/DC converter 480 (e.g., charge pump, boost converter) may boost a voltage from the receiver 320 and its energy storage module 197 to combine with a higher voltage from the receiver 415 and its energy storage module 197.

In one example, the RF stage 410 may include multiple receivers for fault tolerance. In this scenario, the receiver 320 and the second receiver 415 may be capturing energy from two separate RF sources. If the RF source that the receiver 320 is tuned to ceases to broadcast, and the receiver 415 was still tuned to an active RF source, the active RF source would continue to provide energy to the processing system 120.

The design of the RF stage 410 may be expanded to include any number of receivers (such as the receiver 450) in order to increase RF energy source redundancy. Furthermore, the processor 178 may detect the loss of signal at a given receiver and, while operating under the power of the active receiver (or receivers), command the inactive receiver (or receivers) to tune to an active RF source (or sources). In this example, the RF stage may implement multiple receivers working cooperatively and in parallel to capture RF energy from multiple sources. In this instance, multiple receivers may be tuned to different RF sources and the sum of their collective energies may be used to power the processing system 120.

FIG. 5 shows a flow chart that illustrates an exemplary method 500 to search for RF signal sources that may provide power to the fluid flow measurement system 100. The operations of the method 500 may be performed under the control, supervision, and/or monitoring of a mode controller (e.g., the processor 178). Operations may also be supplemented or augmented by other processing and/or control elements that may be incorporated by other elements operatively coupled to the processor. Some or all of the operations may be performed by one or more processors executing instructions tangibly embodied in a signal. The processing may be implemented using analog and/or digital hardware or techniques, either alone or in cooperation with one or more processors executing instructions.

The method 500 may be performed using the system 100 of FIGS. 1-2. In some implementations, the method 500 includes operations that may be performed generally by, for example, the energy capture module 105 in cooperation with the processing system 120 during fluid flow measurement operations. In the example of FIG. 1, the energy capture module 105 may receive commands from the processor 178 and capture RF energy from the signal sources 194, 195, and/or 196.

The exemplary method 500 begins at step 502, in which the processor 178 receives an instruction to execute an RF energy search. This instruction may come from any number of external sources (e.g., a press of a button on the processing system 120, a transmission from a central location, a signal from a technician's diagnostic device, a pager, or cellular data link), or from various internal sources (e.g., a real-time clock, power monitoring circuitry, and/or environmental sensors).

At step 504, present conditions are determined. In some implementations, the processor 178 may determine the time of day in response to a signal from a real time clock (not shown). Determining present conditions may include checking the time and/or date to adjust dynamically for changes in RF signals, the signal strength of which may depend on the day of the week, month, season, or year. The determination of present conditions may include the use of sensors (not shown) for the measurement of environmental conditions, such as temperature and/or humidity, which may affect, for example, the propagation of RF signals through the atmosphere.

Based on the determined present conditions, a frequency sweep profile is determined at step 506. Signal strength information associated with each of a number of frequencies is used to sweep a band of frequencies that may be different from frequency bands that may be selected under a different set of present conditions. For example, it may be determined that the AM radio band should be swept during daytime hours, but it may be determined that the FM radio band should be swept at night. A single frequency is then selected from the determined frequency sweep profile at step 508.

At step 510, a receiver is tuned to the selected frequency. Optionally, some embodiments may further include varying the passband of the receiver (e.g., by varying the Q factor). Accordingly, the fluid flow measurement system may measure and store energy capture rates at various combinations of selected frequency and passband.

The strength of the received signal at the selected frequency is evaluated at step 512. In some embodiments, this functionality may be part of the receiver (such as the receiver 315), or measured by an A/D converter (such as the A/D converter 174). At step 514, the measured strength of the received signal is compared to a minimum threshold value. In one example, this threshold value may be equal to or above a break-even point at which the captured RF power substantially equals the power consumed to capture the RF energy. In some implementations, the threshold value may be set at the time of manufacturing, set during field service, or determined dynamically by monitoring the system's power consumption, for example. A selected threshold value may be used, for example, to trigger a search for a new RF source signal when a measured voltage (e.g., across a resistor) falls below the selected threshold value.

In the depicted example, if the signal strength does not exceed this threshold, then step 508 is repeated. If, at step 514, the received signal strength satisfies the threshold criteria, then at step 516 information about the selected frequency, signal strength, and present condition information (determined at step 504) is stored for later use.

If another frequency needs to be checked at step 518, then step 508 is repeated. If, however, there are no more frequencies to check, then, at step 520, a comparison of all the stored signal information (stored during step 516) is made to identify the strongest stored signal for the present conditions. At step 522, the receiver is tuned to the frequency of the signal identified at step 520 to collect RF energy at the identified frequency.

If at step 524 there are multiple receivers in the RF stage (e.g., RF stage 410), and additional receivers have been identified as needing tuning but have not yet been tuned, at step 526, the next receiver is tuned and step 504 is repeated. If, at step 524, there are no additional receivers to tune, then the method 500 ends.

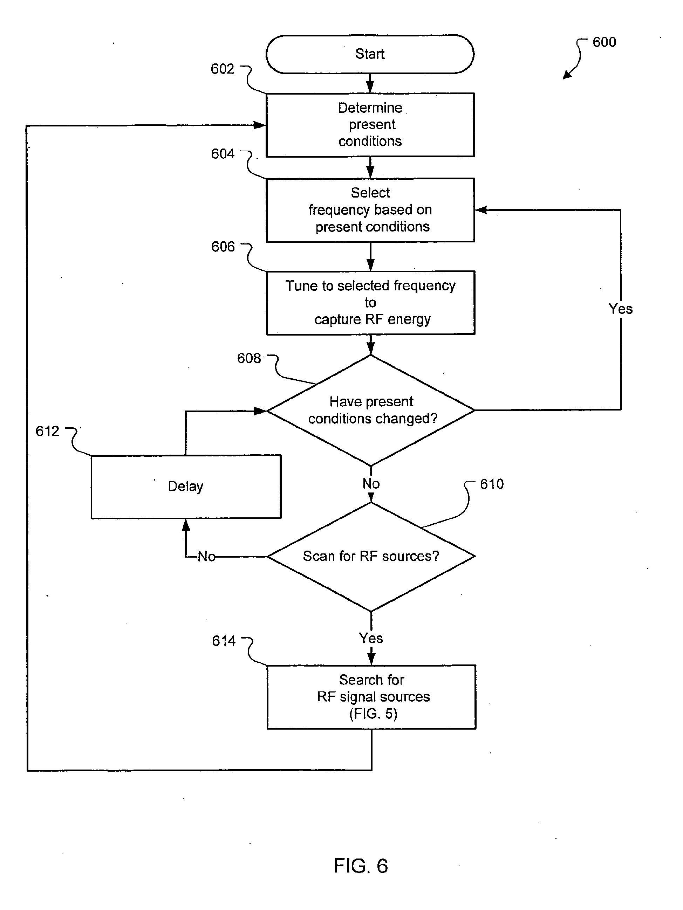

FIG 6 shows a flow chart that illustrates an exemplary method 600 for determining when frequency sweep operations may be performed during the operation of the fluid flow measurement system 100. In some embodiments, the method 600 may be performed substantially continuously during operation of the system 100, in response to an external command input, or as needed to charge batteries, for example.

The method begins at step 602, at which present conditions are determined. This step may be initiated in a variety of ways, such as at power-up, from an external stimulus given by a sensor, from a "wake up alarm" signal from a real-time clock, or by an internal software loop.

At step 604, a frequency is selected based on present conditions. Signal source data (such as the signal source data 183) may be read to select a stored frequency or frequencies. The signal source data may be preset at the time of manufacturing, and/or the signal source data may be saved and/or updated after manufacturing by interaction with a technician's diagnostic tool, by interaction with a user interface that is included in the fluid flow measurement system, by communicating with some other external entity (e.g., operator, tool, device). This interaction, for example, may be repeated a number of times to reset or update the values stored therein. The receiver or receivers are then tuned to the selected frequency in order to capture RF energy at step 606.

Signals selected to be used under one set of present conditions may be different from those selected to be used under a different set of present conditions. At step 608, the present conditions may be determined to see if they have changed since the last time they were determined. If they have changed, then step 604 is repeated. If present conditions have not changed, then step 610 is performed.

A determination is made at step 610 as to whether it is time to perform a scan for RF sources. Fluid flow measurement systems may operate for extended periods in remote locations, and the availability of local RF signal sources may change in terms of frequency and strength over time. In some embodiments, the system may autonomously scan for updated RF signal sources and may update the signal source data 183 accordingly.

If in step 610 it is determined that it is not time to scan for RF sources, then, for example, at step 612 a delay, wait, or sleep period is implemented in order to slow down or pause the cycle of checking for changed conditions, and/or the cycle of performing RF scans. This may be done, for example, in order to improve processor usage or to reduce power consumption. If at step 610 it is determined that it is time to scan for RF sources, then a search for RF signal sources is performed at step 614. An example of operations to search for RF signal sources is described with reference to the method 500 of FIG. 5.

The search for RF signal sources may yield information (e.g., updated frequency, strength, present condition) that may be stored as signal source data 183 (FIG. 1). Then, step 602 is repeated.

In some embodiments, RF scanning operations may be performed infrequently. For example, in the case of a single receiver RF stage (such as the RF stage 190), the fluid flow measurement system 100 may operate using energy stored in the energy storage module 198, or using energy supplied from the auxiliary energy source 188 during this period. If the system 100 were operating on stored energy, then that energy may become depleted during the scan operation if substantial portions of the frequency band lack usable RF signals. In some embodiments, frequency scans may be performed at relatively infrequent intervals in order to minimize the occurrence of the power drain associated with the RF scan process. In some embodiments, this method may cause the execution of a frequency scan to occur only when stored energy exceeds a certain threshold level. In some embodiments, the frequency scan may execute as an emergency measure when small amounts of power are being collected from known RF sources. In some embodiments, the frequency scan operation may be triggered in response to a control input signal.

In the case of embodiments of a fluid flow measurement system 100 that use an energy capture module with multiple receivers (such as the energy capture module 405 and the RF stage 410), the determination of when to perform a signal scan may depend upon the implementation of the scan process and the configuration and utilization of the receivers. For example, if one or more receivers in a collection of receivers is tuned to supply enough energy to power the system 100, then any or all of the remaining receivers may perform signal scans singularly or in combination since they may not be needed for power. In such configurations, the scan process may be implemented to balance RF energy collection and/or RF energy source redundancy with the costs of scanning RF sources (where all receivers may scan in combination using stored energy from the energy storage 197 or from the auxiliary power 188).

The interval in which the receiver 192 may be retuned, and/or RF scans may be executed may be based on several different factors. For example, the interval may be performed as a function of time (e.g., once per hour, once per day, monthly, seasonally). The system 120 may scan once per month in order to remove absent, formerly active RF sources and to identify new ones (e.g., a new cellular tower that may have recently been activated nearby, or a wireless Ethernet access point may have been installed in the vicinity).

In some embodiments, the interval in which the receiver 192 may be retuned and/or RF scans may be performed may be based on environmental factors such as humidity or temperature. For example, high humidity may attenuate the strength of an RF signal. If the processor 178 is capable of sensing this condition, it may retune the receiver to a better performing frequency, and/or may trigger a frequency search that scans RF bands that are less susceptible to attenuation under humid conditions.

In some embodiments, the processor 178 may be programmed to avoid tuning to or scanning AM bands near dusk and/or dawn (e.g., based on real-time clock information, photodector signal) when some RF sources are switched between daytime and nighttime operations. For example, some AM radio broadcasters reduce their transmission power (or even cease transmission entirely) at night due to changes in the ionosphere; such changes may occur around dusk and dawn. AM broadcasters, for example, may change their transmission power at those times. In some implementations, an AM radio signal may offer sufficient power during the day but not at night, or vice versa. For example, the receiver 315 may be tuned to a strong AM signal during the day, but as nightfall approaches, the processor 178 may receive a signal from an internal real-time clock (not shown) to select another (e.g., stronger) signal than what the AM signal will be during nighttime operation. This process may reverse itself in the morning, with the processor 178 receiving a signal from the real-time clock to switch back over to the previous AM source once it has resumed daytime operation.

In various embodiments, the interval in which a receiver 192 in a fluid flow measurement system may be retuned, and/or RF scans may be executed may be based on conditions internal to the system 120. Conditions may include power state, total received power, and/or stored energy levels. For example, the processor 178 may be able to sense the amount of energy that is being derived from RF sources. Under some circumstances the power state conditions of the system 120 may change if the level of captured RF energy changes. In some embodiments, the processor may be able to monitor the energy stored in the energy storage module 198. For example, the power state conditions of system 120 may change as a battery is drained, prompting the need to find alternative RF signal sources in order to collect RF energy that may be used to recharge it. In some embodiments, the processor 178 may monitor the status of external power sources, such as that supplied by the auxiliary energy source 188. For example, power state conditions may change if external power is cut, and the system may respond by switching to the use of RF energy. The state of power consumption may influence the selection of RF signal sources, or trigger a scan for RF sources. For example, if the system 120 is tuned to an active RF signal source and the processor 178 is in a "sleep" state, the current RF energy source may supply sufficient power to operate the system 120. However, the higher current demands of the processor 178 in an "awake" state may prompt the system to seek out stronger sources of RF energy.

Other factors that could influence the interval in which a receiver 192 may be retuned, and/or RF scans may be executed include, but are not limited to, randomly timed intervals and/or external stimulus or signals.

Although exemplary fluid flow measurement system implementations have been described, other implementations may be deployed in various remote, industrial, commercial, and/or residential fluid flow measurement applications.

For example, the system 120 and process 500 may store information in addition to the latest updated frequency, strength, and condition data as the signal source data 183. Additional information may include, but is not limited to, historical, statistical, and/or trend information (e.g., selected frequencies, signal strengths, operating conditions, and/or date stamp information) that may be useful for determining hardware and/or software upgrade packages, or for designing future embodiments of the fluid flow measurement system. This data may, for example, help designers to improve antenna and receiver designs, more accurately model the physical environment in which fluid flow measurement systems may be deployed, and/or provide more accurate signal source data 183 to preload into new systems as they are manufactured.

In some implementations, historical information may also be used to improve maintenance operations. For example, historical, trend, and/or processed statistical data that is collected and stored in a data store in the fluid flow measurement system may provide maintenance technicians information about, for example, peak, minimum, and average energy capture rates in an individual fluid flow measurement system. Such information may be used to substantially extend an operating life of a backup battery, for example. Data may be used to schedule maintenance based on a projection of the replacement interval for batteries in particular installations or environments. As such, data stored in a fluid flow measurement system may be used to reduce maintenance costs by, for example, scheduling field maintenance routines that are neither too frequent or too infrequent.

This additional information stored in a data store of the fluid flow measurement system may also include, but is not limited to, error and event information, which may be used for diagnosing intermittent problems that may occur, for example, during remote fluid flow measurement operations. Exemplary error information may include internal error and fault codes. Exemplary event information may include information about when an RF source becomes unavailable, or what present conditions changed in order to trigger an RF signal scan.

In some implementations, information about local high energy RF sources may be downloaded from an external data source into a data store of the fluid flow measurement system. The downloaded information may specify frequency bands and/or specific frequencies to monitor, and in some embodiments, each frequency may be associated with an expected signal strength profile (e.g., single value, night/day values, hourly values, seasonal values, and the like) or a priority index. In one embodiment, selecting a frequency at which to capture energy may include steps of receiving a frequency information from the data store based upon expected signal strength information or a priority index associated with the frequency. After selecting the first frequency, the energy capture rate at the selected frequency is determined and compared to a target rate. If, for example, the average power being captured is less than the target rate, then another frequency may be selected from the data store, the selection being based on the next highest expected signal strength information or priority index, for example.

In some embodiments, frequency selection may involve selecting frequencies that were downloaded into the data store from an external data source, selecting frequencies based on downloaded signal strength information or priority information, selecting frequencies based on data collected from performing frequency scan operations (examples of which are described with reference to FIG. 5, for example), or combinations thereof. For example, energy capture operations may begin by attempting to collect energy from any of three default sources and, if the default RF sources do not yield a target energy capture rate, then selecting frequencies identified by performing frequency scan operations.

Data stored in a data store of the fluid flow measurement system may be read, updated, deleted, or modified, for example, by external devices. For example, stored data may be accessed by a technician's diagnostic tool, or a remote base (e.g., via radio modem, cellular uplink, modem, internet connection). Some embodiments may use the display 186 to inform and/or interact with a user or technician to display collected data, configuration, and/or status information. For example, a display device may indicate whether a target energy capture rate is currently being met, which may aid in the installation, configuration, or troubleshooting of the fluid flow measurement system.

In various embodiments, the processing system 120 or the energy capture module 105 may communicate using suitable communication methods, equipment, and techniques. For example, the module 105 may communicate with a portable computer using point-to-point communication in which a message is transported directly from the source to the receiver over a dedicated physical link (e.g., fiber optic link, point-to-point wiring, and daisy-chain). Other embodiments may transport messages by broadcasting to all or substantially all devices that are coupled together by a communication network, for example, by using omnidirectional radio frequency (RF) signals, while still other embodiments may transport messages characterized by high directivity, such as RF signals transmitted using directional (i.e., narrow beam) antennas or infrared signals that may optionally be used with focusing optics. Still other embodiments are possible using appropriate interfaces and protocols such as, by way of example and not intended to be limiting, RS-232, RS-422, RS-485, 802.11 a/b/g, Wi-Fi, Ethernet, IrDA, FDDI (fiber distributed data interface), token-ring networks, or multiplexing techniques based on frequency, time, or code division. Some implementations may optionally incorporate features such as error checking and correction (ECC) for data integrity, or security measures, such as encryption (e.g., WEP) and password protection.

Temporary auxiliary energy inputs may be received, for example, to re-charge batteries. Some embodiments may operate with other DC voltage sources, such as 9V (nominal) batteries, for example. Alternating current (AC) inputs, which may be provided, for example from a 50/60 Hz power port, or from a portable electric generator, may be received via a rectifier and appropriate scaling. Provision for AC (e.g., sine wave, square wave, triangular wave, or the like) inputs may include a line frequency transformer to perform isolation, voltage step-up, or voltage step-down.

Although various embodiments have been described with reference to RF sources and signals, such embodiments are not necessarily limited to a particular frequency range. As used herein, embodiments may be implemented to receive RF sources and signals that include any radiated electromagnetic energy signals of any frequency that may be suitable for reception and capture.

A number of embodiments of the invention have been described. Nevertheless, it will be understood that various modifications may be made without departing from the spirit and scope of the invention. For example, advantageous results may be achieved if the steps of the disclosed techniques were performed in a different sequence, if components in the disclosed systems were combined in a different manner, or if the components were replaced or supplemented by other components. The functions and processes (including algorithms) may be performed in hardware, software, or a combination thereof. Accordingly, other embodiments are within the scope of the following claims.

## Claims

1. A fluid flow totalizer system comprising:
a processor configured to generate a signal that represents a measure of a flow of a fluid in response to a signal received from a fluid flow sensor;
a receiver stage operable to receive radio frequency (RF) signals at an RF port, and tunable to any of a plurality of RF frequencies in response to a control signal; and
a power supply stage coupled to receive energy received by the receiver stage, and to supply operating power to operate the processor.

2. The system of claim 1, wherein the fluid flow sensor comprises a gas volume meter.

3. The system of claim 1, wherein the fluid flow sensor comprises a liquid flow meter.

4. The system of claim 3, wherein the liquid flow meter comprises a member of the group consisting of a turbine, a diaphragm, and an orifice flow meter.

5. The system of claim 1, wherein the processor operates to adjust the measure of fluid flow to correct for temperature or pressure conditions in the fluid.

6. The system of claim 1, further comprising an antenna coupled to the RF port.

7. The system of claim 1, further comprising a second receiver stage to receive radio frequency (RF) signals at a second RF port, and tunable to any of a second plurality of RF frequencies in response to a second control signal, the power supply stage being further coupled to receive energy received by the second receiver stage.

8. The system of claim 7, further comprising an antenna coupled to the second RF port.

9. The system of claim 1, wherein the receiver stage supplies received energy substantially directly to the power supply stage.

10. The system of claim 1, further comprising an energy storage stage to store energy received from the receiver stage.

11. The system of claim 10, wherein the energy storage module comprises terminals connectable to one or more batteries.

12. The system of claim 10, wherein the energy storage stage is further to supply the received energy to the power supply stage.

13. The system of claim 10, wherein the energy storage module further comprises a battery charging module for charging one or more battery cells using energy received from the receiver stage.

14. The system of claim 1, further comprising a transmit stage to transmit information in the form of RF signals to the RF port.

15. A method of measuring fluid flow, the method comprising:
receiving fluid flow measurement data from a fluid flow meter;
accumulating the fluid flow measurement data with a data processor;
selecting a frequency to capture radio frequency (RF) energy;
receiving RF signal energy at a receiver tuned to the selected frequency;
converting the received RF signal energy to a supply of electrical energy; and
using the supply of electrical energy to operate the data processor.

16. The method of claim 15, further comprising tuning the receiver to the selected frequency.

17. The method of claim 15, wherein selecting a frequency comprises selecting the frequency from a plurality of frequencies based on signal strength information associated with each of the frequencies.

18. The method of claim 15, wherein using the supply of electrical energy to operate the data processor comprises charging a battery to store at least a portion of the supply of electrical energy.

19. The method of claim 15, wherein selecting the frequency comprises tuning a receiver to a plurality of frequencies to determine a signal strength at each of the frequencies.

20. The method of claim 15, further comprising transmitting information stored in a data store coupled to the data processor.

21. A fluid flow metering system, comprising:
a fluid flow sensor;
a processing system to perform fluid flow measurement operations that comprise accumulating fluid flow measurement data from the fluid flow sensor; and
means for converting ambient radio frequency energy to a supply of electrical energy available to operate the processing system.

22. The system of claim 21, further comprising means for selecting a frequency of operation for the converting means.

23. The system of claim 22, wherein the frequency selection is based on signal strength information stored in a data store coupled to the processing system.
